# EUROPÄISCHE PATENTANMELDUNG

(11) **EP 0 845 710 A1**
(43) Veröffentlichungstag der Anmeldung: **03.06.1998**
(21) Anmeldenummer: 96119213.5
(22) Anmeldetag: 29.11.1996
(51) Int. Cl.: G03F 7/20, G03F 7/24, G03F 7/12

(54) **Verfahren und Vorrichtung zur Herstellung einer Druckschablone**

(71) Anmelder: Schablonentechnik Kufstein Aktiengesellschaft, 6330 Kufstein (AT)
(72) Erfinder: Huber, Ralph, 6322 Kirchbichl (AT)
(74) Vertreter: Urner, Peter, Dipl.-Phys.

(57) **Zusammenfassung**

Die Erfindung betrifft ein Verfahren und eine Vorrichtung zur Herstellung einer Druckschablone. Dabei wird eine auf einem Schablonen-Grundkörper (41) befindliche lichtempfindliche Schicht (42) musterbedingt belichtet. Die Belichtung erfolgt erfindungsgemäß über eine Flüssigkristall-Anzeigeeinrichtung (16).

## Beschreibung

Die Erfindung betrifft ein Verfahren zur Herstellung einer Druckschablone gemäß dem Oberbegriff des Patentanspruchs 1 sowie eine Vorrichtung zur Herstellung einer derartigen Druckschablone gemäß dem Oberbegriff des Patentanspruchs 15.

Bei der Herstellung von Druckschablonen wird üblicherweise so vorgegangen, daß eine auf einem Schablonen-Grundkörper befindliche lichtempfindliche Schicht musterbedingt belichtet und anschließend entwickelt wird. Dabei dienen eine Aufspanneinrichtung zum Aufspannen eines die lichtempfindliche Schicht tragenden Schablonen-Grundkörpers, eine Belichtungseinrichtung zur musterbedingten Belichtung der lichtempfindlichen Schicht, eine Antriebseinrichtung zur Relativbewegung von Aufspanneinrichtung und Belichtungseinrichtung gegeneinander, und eine Steuereinrichtung zur Steuerung der Belichtungseinrichtung und der Antriebseinrichtung.

Bei der Erzeugung von z. B. Flachschablonen für den Siebdruck wird üblicherweise so vorgegangen, daß zunächst ein rechteckiger Rahmen mit einem Stahlhohlprofilrohr mit Schablonengaze bespannt und anschließend mit lichtempfindlichem Lack beschichtet wird. Nach dem Trocknen dieses Lackes wird ein Ganzfilm über die Schablone gelegt, also ein Film, der die gesamte Schablonenoberfläche welche im nachfolgenden Druckprozess Druckfarbe hindurchlassen muß, abdeckt. Der Film zeigt das auf die Schablone zu übertragende Muster. Anschließend wird durch den Film hindurch belichtet. Entweder wird die Schablone dem Sonnenlicht ausgesetzt oder durch eine Lichtquelle bestrahlt, die einen möglichst hohen Anteil kurzwelliger Strahlung aufweist. Solche Lichtquellen sind entweder Quecksilberdampflampen, Xenonlampen, Leuchtstoffröhren oder Metall-Halogendampflampen. Die Forderung nach einem möglichst hohen Anteil kurzwelliger Strahlung folgt aus der Lichtempfindlichkeit der verfügbaren Fotolacke. Ursprünglich hat man zur Herstellung eines lichtempfindlichen Lackes Gelatine verwendet, der einige wenige Prozente einer Kaliumbichromatlösung zugesetzt wurden. Setzt man eine so behandelte Gelatine UV-Licht aus, dann vernetzt diese. Durch die Vernetzung wird die Gelatineschicht wasserunlöslich und die nicht bestrahlten Flächen der Schablone können mit Warmwasser aus dem Sieb gewaschen werden. Diese Siebbereiche lassen dann im nachfolgenden Druckprozess Farbe hindurchtreten. Die Gelatine wird heute gerne durch Polyvenylalkohol (=PVA) ersetzt. PVA ist ein synthetisches Thermoplast, welches im unvernetzten Zustand ebenfalls wasserlöslich ist. Der chemische Aufbau von Gelatine und Polyvenylalkohol ist sehr ähnlich. Nachteilig bei diesem Verfahren sind die Notwendigkeit eines Ganzfilmes je Schablone und der große Anteil des umweltbelastenden Kaliumbichromats. Der Ganzfilm verteuert die Herstellung der Schablone und belastet über dies durch die ebenfalls notwendige Naßentwicklung die Umwelt. Um das Kaliumbichromat zu vermeiden, versuchte man schon sehr bald, diese älteren Fotolacke durch Epoxidharze, Polyesterharze und Polyacrylharze zu ersetzen, welchen man zur leichteren lichtinduzierten Polymerisation auch einen Fotosensibilisator beisetzen konnte. Die aus diesen Harzen bestehende Beschichtung der genannten Schablonen wurde aber auch für ein anderes Verfahren verwendet, bei welchem man einen digital gesteuerten Laser als Lichtquelle verwendete. Dieses Verfahren sparte den Ganzfilm. Der Laserstrahl wird durch einen rotierenden Polygonalspiegel parallel zu einer Kantenrichtung über die ganze Breite der Schablone ausgelenkt und diese langsam in der dazu senkrecht stehenden Richtung schrittweise vorgeschoben. Der Laserstrahl durchläuft eine optische Linse mit einem Brennweitenverlauf, welche den Laserstrahl auf seine Auftreffstelle auf der Schablone fokussiert. Die mit dem Fotolack beschichtete Schablone wird so punktweise vernetzt bzw. gehärtet. Der Laser ist aber teuer und man benötigt wegen der extrem kurzen Belichtungszeit und dem bekannten Kurzzeiteffekt zur Aushärtung eine sehr viel höhere optische Stahlenergie als bei längeren Belichtungszeiten. Außerdem haben jene Laser, welche im kurzwelligen bzw. sichtbaren Wellenlängengebiet emittieren, einen sehr schlechten Gesamtwirkungsgrad. Dieser ist oft nicht größer als 0,0001, also 0,01 Prozent. Jede herkömmliche Lichtquelle (Quecksilberdampflampe, Xenonstrahler. Leuchtstoffröhre) weist wesentlich höhere Wirkungsgrade auf. Ein Laser, der Strahlung mit einer Wellenlänge von 388 nm emittiert, benötigt bei einer Abgabe von 30 mW optischer Strahlungsleistung eine elektrische Eingangsleistung von etwa 7 kW.

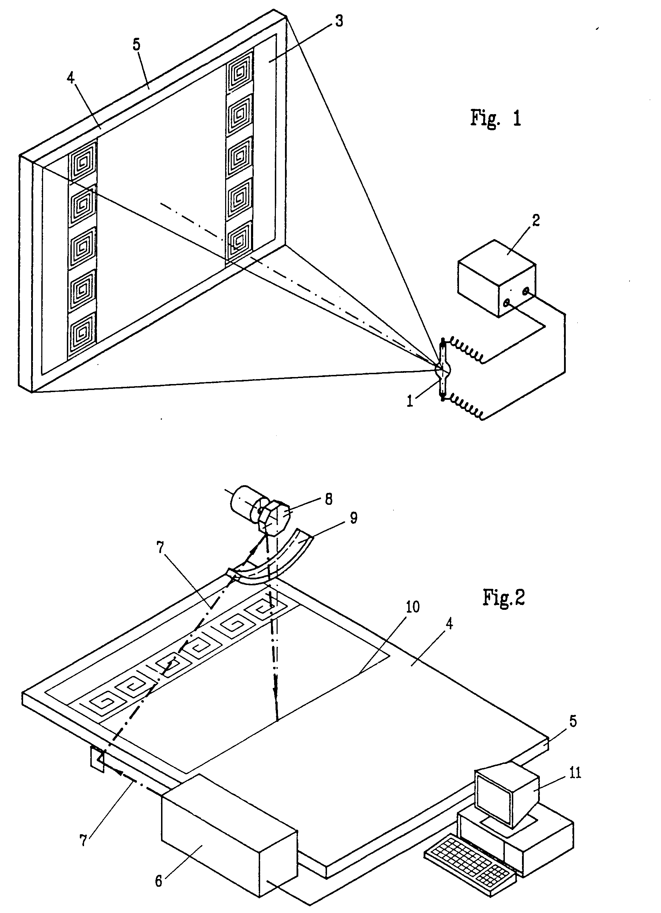

Die Figuren 1 und 2 zeigen die herkömmlichen Belichtungsverfahren zur Herstellung von Flachdruckschablonen. Dabei zeigt die Figur 1 ein älteres Verfahren, nämlich eine Belichtung mit einem Xenonbrenner 1. Der Xenonbrenner 1 wird durch ein Netzgerät 2 mit elektrischer Energie versorgt. Die Belichtung erfolgt durch einen Ganzfilm 3 hindurch auf eine Flachschablone 4. Diese Flachschablone 4 besteht aus einem umlaufenden Rahmen 5, auf welchem eine Seidengaze aufgezogen wird und welche durch einen der zuvor erwähnten lichtempfindlichen Lacke farb- bzw. wasserdicht verschlossen ist.

Die Figur 2 zeigt ein neueres Verfahren mittels der Belichtung durch einen Laser 6. Der Laser 6 emittiert einen Laserstrahl 7, der von einem rotierenden Polygonalspiegel 8 durch eine Optik 9 gelenkt wird. Diese Optik 9 weist eine veränderliche Brennweite auf. Der Laserstrahl 7 läuft entlang einer Geraden 10 quer über die Flachschablone 4 hinweg und härtet oder schädigt dort den aufder Seidengaze befindlichen Fotolack. Gesteuert wird dieser Prozess durch einen Rechner 11.

Sofern Rundschablonen betroffen sind, ist die Belichtung über einen Ganzfilm z. B. aus der DE-OS 29 02 902 bekannt. Dagegen ist die Belichtung mit Hilfe eines Laserstrahls etwa aus der DD 241 567 bekannt. Dort wird die strahlungsempfindliche Lackschicht allerdings weggebrannt. Die Belichtung einer Lackschicht mittels eines Laserstrahls und anschließender Entwicklung im Falle von Rundschablonen geht aus der EP 0 728 578 A1 als bekannt hervor.

Der Erfindung liegt die Aufgabe zugrunde, ein Verfahren der eingangs genannten Art so weiterzubilden, daß eine einfachere und billigere Herstellung von Druckschablonen möglich ist. Für diesen Zweck soll auch eine entsprechende Vorrichtung zur Verfügung gestellt werden.

Die verfahrensseitige Lösung der gestellten Aufgabe besteht darin, daß die Belichtung der lichtempfindlichen Schicht über eine Flussigkristall-Anzeigeeinrichtung erfolgt. Erfindungsgemäß weist somit auch die Vorrichtung zur Herstellung einer Druckschablone eine Belichtungseinrichtung auf, die eine Flüssigkristall-Anzeigeeinrichtung enthält, die durch die Steuereinrichtung ansteuerbar ist.

Der Vorteil des Einsatzes einer Flussigkristall-Anzeigeeinrichtung bei der Belichtung der lichtempfindlichen Schicht ist darin zu sehen, daß im Hinblick auf die Verwendung eines Ganzfilms zum Zwecke der Belichtung die umständliche Herstellung und Anbringung des Ganzfilms auf der Druckschablone entfallen kann. Andererseits ergibt sich gegenüber der Verwendung eines Laserstrahls zum Zwecke der Belichtung der lichtempfindlichen Schicht der Vorteil, daß kein teuerer Laser mehr erforderlich ist, und daß sich darüber hinaus der Gesamtwirkungsgrad im Hinblick auf die aufzuwendende Energie bei der Belichtung verringert. Da die Flüssigkristall-Anzeigeeinrichtung relativ groß ausgebildet sein kann, lassen sich durch einenjeweiligen Belichtungsprozess größere Bereiche des Gesamtmusters herstellen, so daß die Zeiten für die Belichtung der gesamten Schablone mit Hilfe eines Laserstrahls oder mittels der Flüssigkristall-Anzeigeeinrichtung etwa in derselben Größenordnung liegt.

Die lichtempfindliche Schicht konnte generell als eine einzelne Schicht oder aber auch als Mehrschichtsystem ausgebildet sein, z. B. als Zweischichtsystem. bei dem eine höher lichtempfindliche Schicht oberhalb einer weniger lichtempfindlichen Schicht zu liegen kommt. Die höher lichtempfindliche Schicht könnte z. B. eine Silberhalogenidschicht sein. Diese Silberhalogenidschicht dient vorzugsweise dazu, die Kontrastverhältnisse von kontrastschwachen LCD-Bildschirmen zu verstärken. Unterhalb der Silberhalogenidschicht könnte dann z. B. eine herkömmliche Fotolackschicht (Positiv- oder Negativ-Fotolackschicht) liegen. Mit der LCD-Anzeigeeinrichtung wird also zunächst die Silberhalogenidschicht belichtet, die anschließend entwickelt wird. Danach erfolgt eine großflächige Belichtung der Schablonenstruktur, um jetzt die freiliegenden Bereiche der unterhalb der Silberhalogenidschicht liegenden weniger lichtempfindlichen Schicht zu belichten. Danach erfolgt ein weiterer Entwicklungsvorgang.

Nach einer Ausgestaltung der Erfindung sind zur Belichtung größerer Bereiche der lichtempfindlichen Schicht die Fltissigkristall-Anzeigeeinrichtung und der Schablonen-Grundkörper relativ zueinander bewegbar. Somit ist es möglich, durch schrittweises Verschieben der die Flüssigkristall-Anzeigeeinrichtung enthaltenden Belichtungseinrichtung oder des Schablonen-Grundkörpers zeitlich aufeinanderfolgend nebeneinanderliegende Musterbereiche zu erzeugen. Grundsätzlich wäre es auch denkbar, für die Belichtung der auf dem Schablonen-Grundkörper liegenden lichtempfindlichen Schicht mehr als eine Belichtungseinrichtung einzusetzen, in denen jeweils eine Flüssigkristall-Anzeigeeinrichtung zur Übertragung eines größeren Musterbereichs enthalten ist. Dabei kann ein Abstand zwischen der Lichtaustrittsfläche der jeweiligen Belichtungseinrichtung und der lichtempfindlichen Schicht eingehalten werden.

Um das durch die Flüssigkristall-Anzeigeeinrichtung dargestellte Muster möglichst scharf und verlustfrei in die lichtempfindliche Schicht übertragen zu können, kommen nach einer weiteren Ausgestaltung der Erfindung die Lichtaustrittsfläche der Flüssigkristall-Anzeigeeinrichtung bei der Belichtung der lichtempfindlichen Schicht und die lichtempfindliche Schicht miteinander in Kontakt.

Nach einer anderen Ausgestaltung der Erfindung ist es aber auch möglich, ein durch die Flüssigkristall-Anzeigeeinrichtung erzeugtes Musterbild durch eine Projektionseinrichtung auf die lichtempfindliche Schicht zu projizieren, wobei dann auch zur besseren Übertragung des Musters in die lichtempfindliche Schicht die Lichtaustrittsfläche der Projektionseinrichtung bei der Belichtung der lichtempfindlichen Schicht mit dieser in Kontakt kommen kann. Die Lichtaustrittsfläche der Projektionseinrichtung kann dabei diejenige einer Fokussierungsoptik oder diejenige einer planparallelen Abschlußglasplatte sein.

Möglich ist es aber auch, ein mit Hilfe der im allgemeinen eben ausgebildeten Flüssigkristall-Anzeigeeinrichtung erzeugtes Musterbild durch eine Projektionseinrichtung auf eine gekrümmte lichtempfindliche Schicht zu projizieren, ohne daß die Lichtaustrittsfläche der Projektionseinrichtung mit der lichtempfindlichen Schicht in Kontakt kommen muß. Wählt man die projizierte Große des aufzubringenden Musters nicht zu groß, dann spielt die Krümmung der lichtempfindlichen Schicht keine große Rolle. Auch in diesem Fall läßt sich somit das Musterbild hinreichend verzerrungsfrei in die lichtempfindliche Schicht übertragen. Da kein Kontakt mehr zwischen der Projektionseinrichtung und der lichtempfindlichen Schicht erforderlich ist, brauchen beide senkrecht zur Oberfläche der lichtempfindlichen Schicht auch nicht mehr relativ zueinander bewegt zu werden, was den Vorteil mit sich bringt, daß die lichtempfindliche Schicht schneller bemustert werden kann.

Mit dem erfindungsgemäßen Verfahren lassen sich Schablonen-Grundkörper belichten, die z. B. als ebenes oder hohlzylindrisches, flexibles Sieb ausgebildet sind. Dieses Sieb kann als Kunststoffsieb oder als Metallsieb vorliegen.

Möglich ist es aber auch, einen Schablonen-Grundkörper aus flexiblem Metallblech mit geschlossener Oberfläche in ebener oder hohlzylindrischer Ausgestaltung zu verwenden. Dies wäre z. B. der Fall, wenn auf diese Weise gelochte Siebe auf galvanischem Wege auf der Oberfläche des Metallblechs zu erzeugen sind, die später abgenommen werden.

Nicht zuletzt lassen sich aber als Schablonen-Grundkörper auch dicke, starre Metallkörper mit geschlossener Oberfläche in ebener oder hohlzylinderförmiger Ausgestaltung einsetzen. Man wurde diesen Weg im Falle der Herstellung von z. B. Tiefdruckschablonen wählen, wo jetzt auf dem Metallkörper die zu bemusternde lichtempfindliche Schicht liegt. Letztere konnte aber auch auf einer flexiblen Kunststoffschicht liegen, die sich ihrerseits auf dem Metallkörper befindet.

In allen den zuvor genannten Fällen wird also die auf dem Schablonen-Grundkörper befindliche lichtempfindliche Schicht, die als Ein- oder Mehrschichtsystem vorliegen kann, belichtet und anschließend durch Entwicklung entfernt, um danach ggf. weitere Schritte durchfuhren zu können.

Im Falle eines ebenen Schablonen-Grundkörpers wird vorzugsweise eine Flu`ssigkristall-Anzeigeeinrichtung bzw. Projektionseinrichtung mit ebener Lichtaustrittsfläche verwendet, um über einen möglichst großen Bereich einen guten Kontakt zwischen der Lichtaustrittsfläche und der zu belichtenden Schicht zu erhalten.

Ist der Schablonen-Grundkörper dagegen als flexibler, hohlzylindrischer Körper ausgebildet, kann ebenfalls eine Fltissigkristall-Anzeigeeinrichtung bzw. Projektionseinrichtung mit ebener Lichtaustrittsfläche zum Einsatz kommen, mit der dann der flexible Schablonen-Grundkörper und mit ihm die auf ihm liegende fotoempfindliche Schicht gegen eine ebene Unterlage gedruckt wird, um auch jetzt wieder einen guten Kontakt zwischen der Lichtaustrittsfläche und der lichtempfindlichen Schicht über einen möglichst großen Bereich erzielen zu können. Allerdings kann im Falle hohlzylindrischer Schablonen-Grundkörper die Belichtung auch berührungslos erfolgen, wie bereits erwähnt.

Andererseits ist es aber auch möglich, bei einem flexiblen oder starren hohlzylindrischen Schablonen-Grundkörper eine Flüssigkristall-Anzeigeeinrichtung bzw. Projektionseinrichtung mit entsprechend gewölbter Lichtaustrittsfläche zu verwenden, deren Wölbung an die Hohlzylinderwölbung angepaßt ist. In diesem Fall könnte ein Kontakt zwischen der Lichtaustrittsfläche und der lichtempfindlichen Schicht erfolgen, ohne daß bei einem flexiblen Schablonen-Grundkörper dieser deformiert werden müßte. Natürlich ließe sich auch im Falle eines starren hohlzylindrischen Schablonen-Grundkörpers ein vollständiger Kontakt zwischen der Lichtaustrittsfläche der Flüssigkristall-Anzeigeeinrichtung bzw. der Projektionseinrichtung und der lichtempfindlichen Schicht realisieren.

Insbesondere im Falle eines flexiblen Schablonen-Grundkörpers kann nach einer Weiterbildung der Erfindung ein Vakuum zwischen der lichtempfindlichen Schicht und der Lichtaustrittsfläche der Flüssigkristall-Anzeigeeinrtchtung bzw. der der Projektionseinrichtung erzeugt werden, um für eine noch engere Anlage von lichtempfindlicher Schicht und Lichtaustrittsfläche aneinander zu sorgen. Dabei wird der flexible Schablonen-Grundkörper gegen die Lichtaustrittsfläche gezogen. Bei starrem Schablonen-Grundkörper könnte andererseits aber auch dafür gesorgt werden, daß die Belichtungseinrichtung nachgiebig gestaltet ist, so daß sie dann im Fall des besagten Vakuums gegen die auf dem starren Grundkörper liegende lichtempfindliche Schicht gezogen werden könnte.

Nach einer vorteilhaften Ausgestaltung der erfindungsgemäßen Vorrichtung kann die strahlausgangsseitig liegende Begrenzungsplatte der Flüssigkristall-Anzeigeeinrichtung durch senkrecht zur Plattenebene liegende Lichtleiter gebildet sein. Auf diese Weise wird die Abstrahlcharakteristik der Flüssigkristall-Anzeigeeinrichtung weiter verbessert, so daß schärfere Bilder erhalten werden.

Nach einer anderen Ausgestaltung der Erfindung kann die Belichtungseinrichtung mit einem optischen Filter versehen sein oder es kann die Flüssigkristall-Anzeigeeinrichtung durch einen aufgeweiteten Laserstrahl einer gewünschten Wellenlänge belichtet werden. Auf diese Weise läßt sich eine Wellenlänge auswählen, die nach Hindurchtreten des Lichts durch den Schirm der Flüssigkristall-Anzeigeeinrichtung das größte Intensitätsverhältnis zwischen den transmittierenden und absorbierenden Bereichen des Schirms ergibt. Dadurch ergibt sich ein verbesserter Kontrast.

In weiterer Ausgestaltung der Erfindung kann die Aufspanneinrichtung als ebener Rahmen ausgebildet sein, welcher sich senkrecht zur Rahmenebene bewegen läßt. Hierdurch kann der Schablonen-Grundkörper in einfacher Weise auf die Belichtungseinrichtung zu oder von dieser weg bewegt werden, so daß es nicht erforderlich ist, zu diesem Zweck die Belichtungseinrichtung selbst und den sie tragenden Antriebsmechanismus zu verschieben.

In Weiterbildung der Erfindung kann die Aufspanneinrichtung auch in Form eines länglichen Trägers mit ebener Oberfläche ausgebildet sein, auf der senkrecht zur Trägerlängsrichtung der Schablonen-Grundkörper transportierbar ist. Ein derartiger Träger kommt insbesondere dann zum Einsatz, wenn der Schablonen-Grundkörper hohlzylindrisch ausgebildet ist. Dabei ragt der Träger von einem Ende in den Hohlzylinder hinein. An beiden Enden des Trägers können nach einer noch weiteren Ausgestaltung der Erfindung Zahnräder für den Transport des Schablonen-Grundkörpers vorhanden sein, deren Zähne in seitlich in den Schablonen-Grundkörper eingebrachte Perforationen eingreifen, um diesen senkrecht zur Längsrichtung des Trägers zu transportieren. Im Belichtungsfall wird dann der Schablonen-Grundkörper durch die Belichtungseinrichtung gegen die ebene Oberfläche des Trägers gedrückt.

Die Zeichnung stellt neben dem Stand der Technik Ausführungsbeispiele der Erfindung dar. Es zeigen:
**Figur 1** eine herkömmliche Einrichtung zur Belichtung einer Flachschablone über einen Ganzfilm:
**Figur 2** eine weitere herkömmliche Einrichtung zur Belichtung einer Flachschablone mittels eines ablenkbaren Laserstrahls;
**Figur 3** eine Vorrichtung zur Belichtung einer Flachschablone in Übereinstimmung mit einem ersten Ausführungsbeispiel der Erfindung;
**Figur 4** einen Längsschnitt durch die Vorrichtung nach Figur 3 im Bereich einer Belichtungseinrichtung;
**Figur 5** einen Querschnitt durch den Aufbau einer Flussigkristall-Anzeigeeinrichtung der Belichtungseinrichtung:
**Figur 6** einen Längsschnitt durch die Vorrichtung nach Figur 3 im Bereich einer anderen Belichtungseinrichtung;
**Figur 7** einen Längsschnitt durch die Vorrichtung nach Figur 3 im Bereich einer noch anderen Belichtungseinrichtung;
**Figur 8** ein weiteres Ausführungsbeispiel der erfindungsgemäßen Vorrichtung zur Belichtung von Rundschablonen, wobei eine Querschnittsdarstellung im Bereich einer Belichtungseinrichtung gezeigt ist;
**Figur 9** einen Längsschnitt durch die Vorrichtung nach Figur 8, wobei die Belichtungseinrichtung der Übersicht wegen fortgelassen ist;
**Figur 10** eine Ansicht auf die Stimseite der Vorrichtung nach Figur 8;
**Figur 11** ein noch weiteres Ausführungsbeispiel einer erfindungsgemäßen Vorrichtung zur berührungslosen Belichtung von starren oder flexiblen Rundschablonen; und
**Figur 12** ein Ausführungsbeispiel mit gekrümmter LCD-Einrichtung.

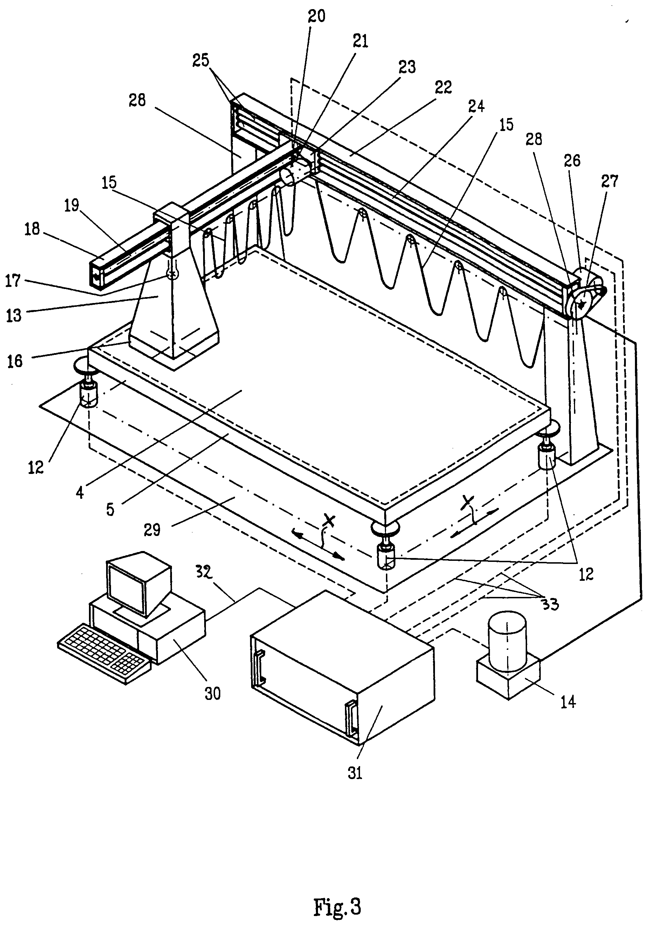

In Figur 3 werden das erfindungsgemäße Belichtungsverfahren und eine Vorrichtung zu dessen Durchführung näher beschrieben. Eine Flachschablone 4 liegt mit ihrem Rand auf vier Hubeinrichtungen 12. Diese Hubeinrichtungen 12 können Elektrohubmagnete, pneumatische oder Hydraulikzylinder sein. Die Flachschablone 4 wird auf diese Hubeinrichtungen 12 gegenüber ihrer Gebrauchslage im Druckprozeß verkehrt aufgelegt, so daß die Seite, welche später mit der zu bedruckenden Warenbahn in Kontakt kommt, hier nach oben zeigt, also in der Figur 3 sichtbar dargestellt ist. Dies trägt zu einem konturenscharfen Druck bei. Die Flachschablone 4 besteht in an sich bekannter Weise aus einem umlaufenden Rahmen 5, der üblicherweise aus vier Stahlprofilrohren mit etwa rechteckigem Querschnitt angefertigt ist. Die Stahlprofilrohe sind an den Eckpunkten der Flachschablone 4 miteinander verschweißt. Über der Flachschablone 4 befindet sich eine Belichtungshaube 13, an deren unteres Ende gemäß der Erfindung eine LCD-Anzeige 16 (= Flüssigkeitskristall-Anzeigeeinrichtung) ausreichender Größe befestigt ist. Eine solche Flussigkristall-Anzeigeeinrichtung 16 besteht bekanntermaßen aus zwei als Elektroden ausgeführten Glasplatten, die mit einem Abstand zueinander montiert sind. Zwischen den beiden Glasplatten befindet sich ein Elektrolyt. Dies ist eine dünne Flüssigkeitsschicht, in welcher organische Moleküle gelöst sind. Die Glasplatten sind auf ihrer der Flüssigkeit zugewandten Innenseite mit einer sehr dünnen, strukturierten Metallbedampfung ausgerüstet. Werden zwei durch die organische Lösung getrennte, gegenüberliegende Elektroden an unterschiedliches elektrisches Potential gelegt, dann wird ein elektrostatisches Feld zwischen den Elektroden aufgebaut und die Moleküle erfahren eine räumliche Ausrichtung. Dadurch ändern sich die optischen Eigenschaften des Flüssigkeitsfilms und Licht wird stärker oder schwächer absorbiert. Diese LCD-Anzeigen 16 sind derzeit in Großen bis zu 17 Zoll = 431,8 mm Bildschirmdiagonale erhältlich. Eine derartige LCD-Anzeige 16 wird in einen möglichst engen Kontakt mit der lichtempfindlichen Lackschicht der Flachschablone 4 gebracht. Zur Unterstützung dieses Vorgangs kann ein Vakuum zwischen der LCD-Anzeige 16 und der Oberfläche der Flachschablone 4 erzeugt werden. Die Luft aus diesem Zwischenraum wird durch eine Vakuumpumpe 14 und über Schleppleitungen 15 abgesaugt. In den oberen Bereich der Belichtungshaube 13 ist eine Lichtquelle 17 eingebaut, welche im UV-Gebiet oder im eher blauen Bereich des sichtbaren Spektrums Strahlung emittiert. Die Belichtungshaube 13 ist nach außen lichtdicht abgeschlossen, so daß Licht nur durch die LCD-Anzeige 16 hindurch auf die Flachschablone 4 fallen kann. Eine Vorbelichtung der Flachschablone 4 durch Streulicht wird so verhindert.

Die Belichtungshaube 13 wird stets um gleichgroße Schritte in x- und y-Richtung verschoben. Die Schrittweite entspricht den Abmessungen der aktiven Fläche der LCD-Anzeige 16. Zum schrittweisen Transport der Belichtungshaube 13 ist in y-Richtung der Kragarm 18 vorgesehen. In dessen Innenbereich läuft eine Spindel 19, die wiederum durch einen Stellmotor 20 über ein Zahnriemenvorgelege 21 betätigt wird. Die LCD-Anzeige 16 muß elektrisch ihrer x,y-Position entsprechend jeweils so angesteuert werden, daß das auf die Flachschablone 4 aufzulichtende Muster ohne Anschlußfehler zwischen den jeweiligen Versatzstellen der Belichtungshaube 13 paßt. Gegenüber den bekannten Filmadditionsmaschinen. bei welchen ein auf einen Film aufgebrachter Einzelrapport auf einen Ganzfilm aufgelichtet wird, hat dieses Verfahren den Vorteil, daß keinerlei Einstellarbeiten wegen unterschiedlicher Größen der Einzelrapporte anfallen. Es wird die Belichtungshaube 13 stets um den gleichen Weg in x- bzw. y-Richtung versetzt. Für den Versatz in x-Richtung sind ein Längsführungsbalken 22 und ein Schlitten 23 vorgesehen. Zwei Rundführungen 25 und eine Stellspindel 24 dienen zur Fuhrung und Bewegung des Schlittens 23. Die Stellspindel 24 wird durch den Motor 26 und über ein Zahnriemenvorgelege 27 angetrieben. Der Längsführungsbalken 22 ist über zwei Säulen 28 auf einer Basisfläche 29 abgestützt.

Vor Beginn der Belichtung wird die Flachschablone 4 auf die Hubeinrichtungen 12 aufgelegt und die Seitenkanten der Flachschablone 4 werden parallel zum Kragarm 18 und zum Längsführungsbalken 22 ausgerichtet. Die Hubeinrichtungen 12 befinden sich im abgesenkten Zustand. Anschließend werden die Hubeinrichtungen 12 mit der darauf befindlichen Flachschablone 4 angehoben, um die Oberfläche der beschichteten Seidengaze möglichst nahe an die LCD-Anzeige 16 heranzufuhren. Außerdem wird die Schablonenfolie 4 durch Erzeugung eines Vakuums zwischen Folie 4 und LCD-Anzeige 16 an diese durch den äußeren Luftdruck angepreßt. Es erfolgt die erste Belichtung. Ein Rechner 30 schaltet über eine Leistungsverstärkereinheit 31 zunächst die Hubeinrichtungen 12 so, daß die Flachschablone 4 angehoben wird, anschließend versorgt er die LCD-Anzeige 16 mit den richtigen Musterdaten und schließlich veranlaßt er das Einschalten der Lichtquelle 17. Je nach optischer Strahlleistung der verwendeten Lichtquelle 17 beträgt die Einschaltdauer entweder einige Sekunden oder mehrere Minuten. Nach dem Ende der Belichtungszeit wird die Lichtquelle 17 ausgeschaltet, das Vakuum abgeschaltet, die Flachschablone 4 mittels der Hubeinrichtungen 12 abgesenkt und die Belichtungshaube 13 um die genaue y-Breite der LCD-Anzeige 16 in y-Richtung oder um die genaue x-Versetzung derselben in x-Richtung verschoben. Das beschriebene Arbeitsspiel wird jetzt wiederholt, aber natürlich mit den passenden. d. h. ggf. abgeänderten Musterdaten, so daß sich insgesamt ein einheitliches Gesamtmuster ergibt.

Der Rechner 30 steuert über eine serielle Datenleitung 32 die Leistungsverstärkereinheit 31 an, welche über eventuell mehradrige Versorgungsleitungen 33 die einzelnen Verbraucher (Antriebe, Lampen, Hubmagnete) entsprechend den Erfordernissen des Arbeitsablaufs ein- oder ausschaltet.

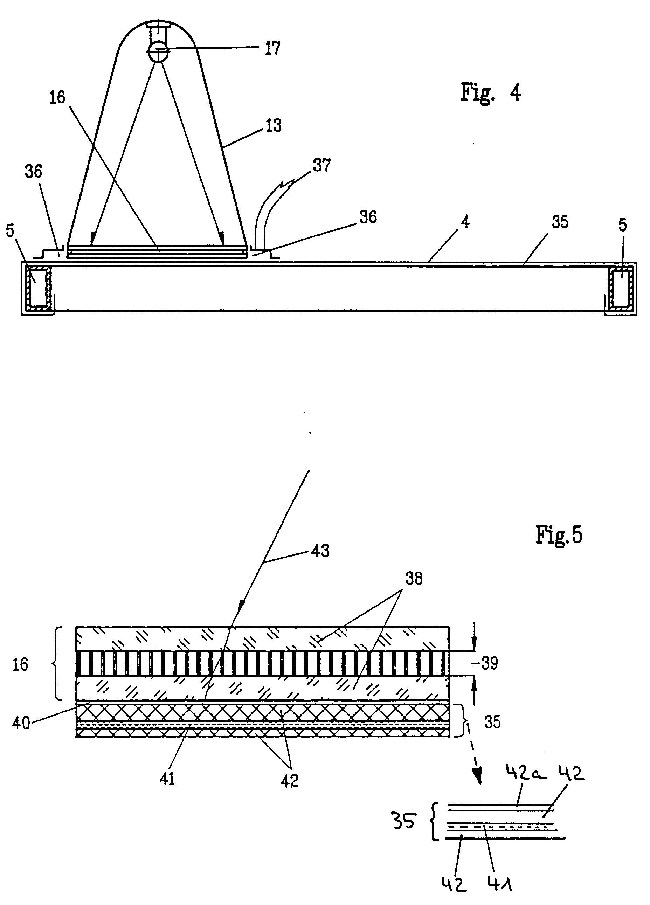

In Figur 4 ist ein Querschnitt durch die Belichtungshaube 13 und die darunter befindliche Flachsschablone 4 gezeigt. Der umlaufende Rahmen 5 besteht aus einem Stahlhohlprofilrohr mit rechteckigem Querschnitt. Die zu gravierende Folie 35 (mit lackbeschichtetem Schablonen-Grundkörper) ist an sich sehr dünn, ihre Dicke beträgt ungefähr 0,1 mm. Deshalb kann sie um das Profilrohr des Rahmens 5 umgeschlagen und mit diesem verklebt werden. Auch ist sie wegen dieser geringen Stärke trotz der Spannung in x- und y-Richtung sehr flexibel, so daß die Folie 35 einwandfrei an jener Oberfläche der LCD-Anzeige 16 anliegt, welche der Folie 35 zugekehrt ist. Ein angelegtes Vakuum zwischen der Folie 35 und der LCD-Anzeige 16 unterstützt dies. Um diesen Bereich zu evakuieren, wird die Luft aus einem um den Umfang der LCD-Anzeige 16 angeordneten Vakuumkanal 36 über die Saugleitung 37 abgesaugt.

In Figur 5 ist stark vergrößert ein Querschnitt durch die LCD-Anzeige 16 und die darunter liegende Folie 35 dargestellt. Der hier gezeigte Spalt 40 zwischen der Folie 35 und der LCD-Anzeige 16 besteht nur vor dem Einschalten des Vakuums, durch das Absaugen vom Luft nach dem Einschalten wird dieser Spalt praktisch ganz zum Verschwinden gebracht. Die LCD-Anzeige 16 besteht, wie bereits erwähnt, aus zwei parallelen Glasplatten 38, zwischen welchen sich ein Spalt 39 befindet. Dieser Spalt 39 ist mit einer elektrisch isolierenden Lösung organischer Moleküle befüllt. Die an den Spalt 39 grenzenden Oberflächen der Glasplatten 38 sind mit einer sehr dünnen leitfähigen Metallschicht bedampft, und zwar etwa so, daß schachbrettartig gegenüberliegende quadratische, sehr kleine Elektroden entstehen. Wenn an die beiden genau gegenüberliegenden Elektroden ein unterschiedliches Spannungspotential angelegt wird, dann verändert sich das Reflexions-Transmissionsverhalten dieser Wände und der dazwischen befindlichen Flüssigkeit so, daß dieser Bereich abgedunkelt erscheint. Die Transmission des Lichtes wird stark behindert, Licht kann an dieser stelle die lichtempfindliche Folie 35 kaum erreichen und je nach verwendetem Fotolack wird die Härtung oder die Schädigung des Lackes verhindert. Bei dieser Einrichtung kann allerdings der eigentlich bildgebende Spalt 39 einen mehr oder weniger großen Abstand von der Folie 35 aufweisen, welcher durch die Dicke der unteren Glasplatte 38 bedingt ist. Wegen dieses Abstandes kann die Bildschärfe dank einer möglichen Unterstrahlung und Kantenstreuung leiden. Auch kann die Abbildung des Musters durch schräg laufende Randstrahlen 43 verzerrt werden.

Aus dieser Figur ist aber auch der Aufbau der Folie 35 ersichtlich. Diese besteht z. B. aus Seidengaze 41 und dem sie umhüllenden und tränkenden Fotolack 42. Dieser Fotolack 42 kann nach einer der üblichen Klassifizierungen ein Positiv- oder Negativlack sein. Ein Positivlack wird bei Belichtung geschädigt und bei der nachfolgenden Entwicklung werden diese belichteten Stellen ausgewaschen. In diese Gruppe gehören die sogenannten Diazoharze. Negativlacke werden bei Belichtung gehärtet und die nicht belichteten Stellenwerden bei der Entwicklung ausgewaschen. Zu dieser Gruppe zählen Acrylharze, Epoxidharze, usw. Die lichtempfindliche Schicht 42 kann darüber hinaus auf ihrer Oberfläche auch noch eine starke lichtempfindliche Schicht 42a tragen. z. B. eine Silberhalogenidschicht, die zunächst durch die LCD-Einrichtung 16 belichtet wird, um dadurch eine Maske für die nachfolgende, z. B. großflächige Belichtung der Schicht 42 zu erhalten.

Um das Bild möglichst scharf auf die Folie 35 zu übertragen, kann die untere der beiden Glasplatten 38, also jene, welche an der Folie 35 anliegt, zweckmäßig auch durch eine Lichtleiterplatte ersetzt werden. Eine Lichtleiterplatte besteht bekanntlich aus Glasfasern mit geringem Durchmesser - im allgemeinen 6 bis 20 µm - und kurzer Länge, die miteinander z. B. durch Epoxidharze oder Acrylatharze verklebt sind. Solche Lichtleiterplatten leiten das Licht nur senkrecht zur Plattenebene. Hier kann der Durchmesser der Glasfasern dem Rastermaß der feinsten herzustellenden Schablone (z. B. Siebschablone) angepaßt werden, das heißt, es können Fasern mit etwas größerem Durchmesser für die Lichtleiterplatte verwendet werden, so daß die Lichtleiterplatte etwas preiswerter wird.

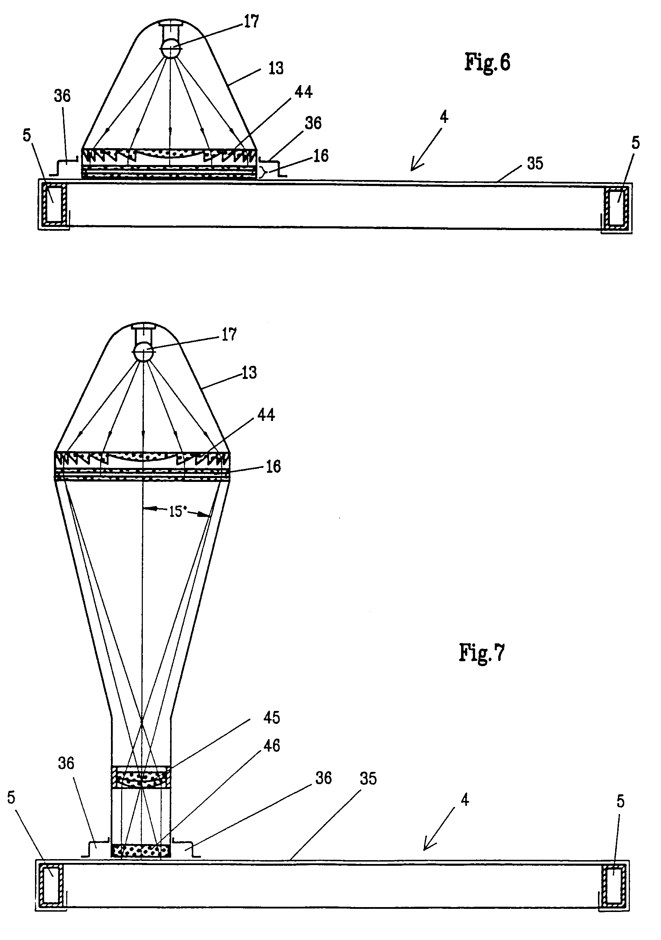

In Figur 6 durchläuft das von der Lichtquelle 17 emittierte Licht einen zwischen der Lichtquelle 17 und der LCD-Anzeige 16 knapp vor letzterer befindlichen Kondensor 44. Dieser Kondensor 44 ist hier als Fresnel-Linse ausgebildet. Die Lichtquelle 17 sitzt etwa im Brennpunkt der Fresnel-Linse. Auch durch diese Maßnahme können Unterstrahlungen der Musterkonturen, die besonders linienartige Motive sehr schädigen, verhindert werden.

Das Ausführungsbeispiel nach Figur 7 zeigt eine Belichtungshaube 13, bei welcher die LCD-Anzeige 16 durch ein Objektiv 45 auf die Oberfläche der Folie 35 bzw. der Flachschablone 4 scharf abgebildet wird. Durch diese optische Übertragung geht zwar ein erheblicher Teil der von der Lichtquelle 17 abgestrahlten Energie verloren, aber das Bild der LCD-Anzeige 16 kann mit wesentlich geringeren Fehlern auf die Flachschablone 4 übertragen werden. Diese Fehler bestehen eigentlich nur aus den Abbildungsfehlern des Objektivs 45, die bei Wahl einer entsprechend hochwertigen Optik praktisch nicht ins Gewicht fallen. Darober hinaus hat diese Anordnung den Vorteil, daß die verhältnismäßig grobe Punktauflösung der LCD-Anzeige 16, etwa 3,5 Punkte pro mm, beliebig verkleinert werden kann. Um bei diesem Ausführungsbeispiel das vom Objektiv erzeugte Bild der LCD-Anzeige 16 genau in die Oberfläche der Folie 35 zu legen, wird die Belichtungshaube 13 mit einer Planglasplatte 46 abgeschlossen. Auch hier kann die Folie 35 mittels Vakuum an die Planglasplatte 46 angelegt werden, die zu diesem Zweck vom Vakuumkanal 36 umgeben ist.

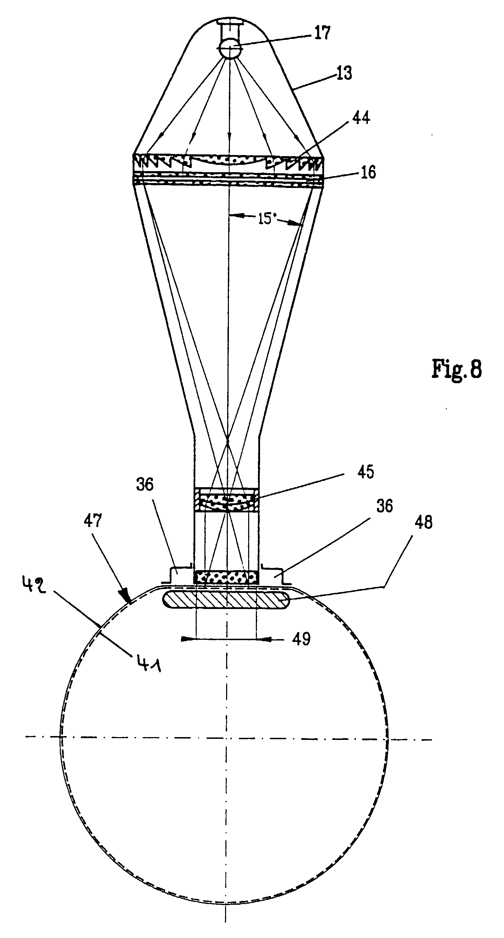

In Figur 8 wird gezeigt, wie der erfindungsgemäße Belichtungsvorgang bei einer Rundschablone 47 angewendet wird. Im allgemeinen sind Rundschablonen stets aus sehr dünnen Siebhohlzylindern 41 angefertigt oder werden auf nahezu ebenso dünnen ungelochten Hohlzylindern galvanoplastisch abgeschieden. Ein solcher Hohlzylinder kann aber über einen kleiner Teil seines Umfangs durch einen geringen Druck flach gepreßt werden, ohne daß unzulässige Spannungen im Blechmantel oder zwischen Blechmantel und Fotolack auftreten. Der mit Fotolack 42 beschichtete Hohlzylinder 41 wird daher auf einen schmalen ebenen Tisch 48 abgestutzt, flach gedrückt und mit Hilfe einer Belichtungshaube 13, wie sie schon in Figur 7 beschrieben wurde, belichtet. Dabei erfolgt ein Versatz der Belichtungshaube 13 in Richtung der Hohlzylinderachse ebenso wie zuvor bei der Herstellung von Flachschablonen. Wenn ein Segment 49 des Hohlzylindermantels über die Länge der Schablone durchgehend bearbeitet, d. h. belichtet wurde, wird der Schablonenumfang um die Höhe des aufgelichteten Bildes nachgeschoben und es erfolgt die Belichtung des folgenden Segments. Hierbei kann man wählen, ob man die Höhe des aufzulichtenden Segments so festlegt, daß dieses ganzzahlig im Umfang der Schablone enthalten ist oder ob man bei der Belichtung des letzten Segments nur den noch verbleibenden, nicht belichteten Restumfang des Hohlzylindermantels behandelt.

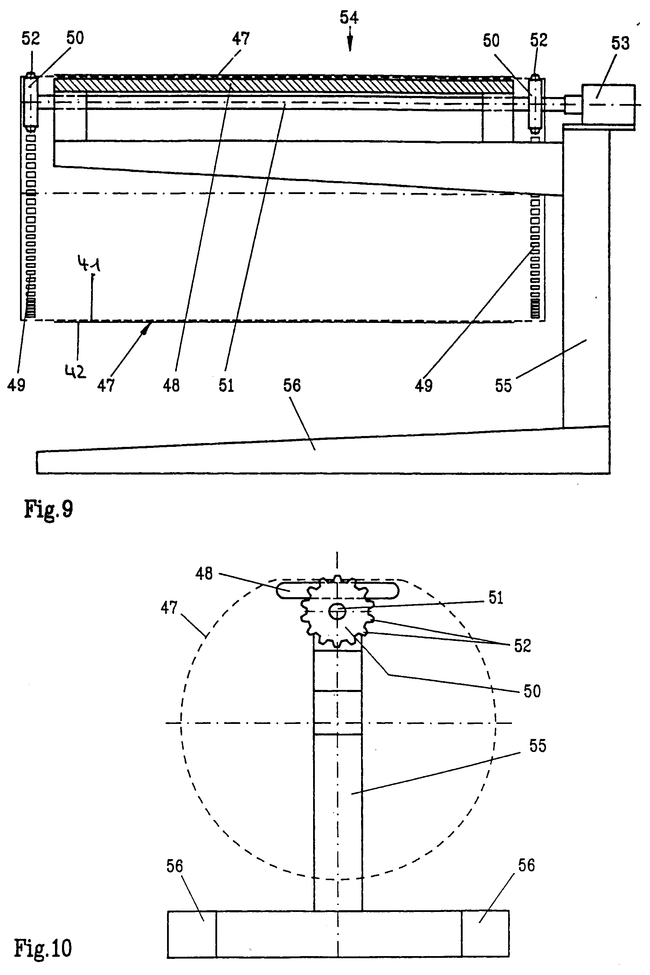

Figur 9 zeigt einen Längsschnitt und Figur 10 einen Querschnitt durch den unteren Teil einer solchen Belichtungseinrichtung für eine Rundschablone. Um die Rundschablone 47 genau vorschieben zu können, ist diese am besten an beiden Rändern mit einer sehr genauen, z. B. Rechtecklochung 49 versehen. Der Abstand der rechteckigen Löcher entspricht der Teilung von Synchronzahnrädern 50, welche durch einen Stellantrieb 53 (z. B. Schrittmotor) gedreht werden. Eine steife Welle 51 verbindet die beiden Synchronzahnräder 50 und sorgt für das gleichmäßige Vorschieben der beiden Schablonenseiten, nachdem jeweils ein Segment der Rundschablone 47 über die gesamte Länge der Rundschablone belichtet wurde. Der Abstand der Welle 51 vom Tisch 48 ist einstellbar, so daß die Synchronzahnräder 50 mit der Welle 51 stets soweit an die Rundschablone 47 herangeführt werden können, daß Zähne 52 der Synchronzahnräder 50 spielfrei in dessen Rechtecklochungen 49 eingreifen. Diese Vorschubantriebsvorrichtung 54 ist an der Seite des Stellantriebs 53 nach Art eines Kragträgers auf einer Säule 55 befestigt. Ein langer Fußteil 56 stützt die komplette Einheit.

Die Erfindung ist auf die dargestellten Ausführungsbeispiele nicht beschränkt. So kann die Belichtung auch mit einer Strahlung bis zu einer Wellenlänge von 2 µm erfolgen. Es können weiters sämtliche handelsüblichen Fotolacke oder lichthärtenden Harze verwendet werden. Auch ist es möglich, zwischen Lichtquelle und LCD-Bildschirm einen optischen Filter vorzusehen, um so nur Licht jener Wellenlänge hindurchtreten zu lassen, welches nach dem LCD-Schirm 16 das größte Intensitätsverhältnis zwischen den transmittierenden und absorbierenden Bereichen des Schirms ergibt. Der gleiche Effekt kann durch eine von Haus aus monochromatische Lichtquelle (Laser) erreicht werden. Im letzten Fall kann es zweckmäßig sein, eine Strahlaufweitungsoptik oder eine Zerstreuungslinse zwischen Laser und LCD-Schirm 16 vorzusehen.

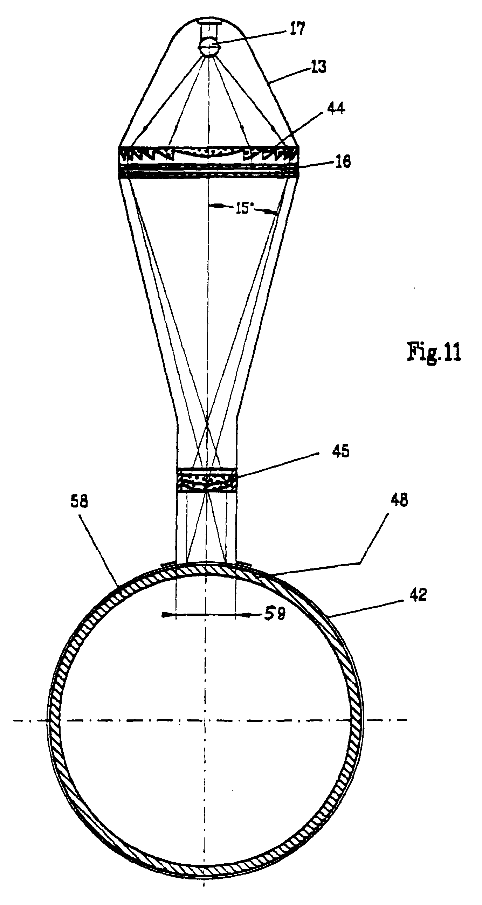

In Figur 11 gelten die gleichen Bezeichnungen wie in Figur 8. Hier wird das Verfahren zusammen mit einer dickwandigen Matrize 58 gezeigt, deren Oberfläche mit einem Fotolack 42 dünn (vorzugsweise 5 bis 30 µm) beschichtet ist. Es soll aufgalvanischem Wege ein hohlzylindrisches Sieb erzeugt werden. Zunächst wird jeweils ein Segment der Breite 59 bestrahlt. Je nach Typ des Fotolacks werden die belichteten Stellen entweder gehärtet (Negativ-Lack) oder durch die Belichtung geschädigt (Positiv-Lack). Es werden so viele Belichtungen durchgeführt, wie notwendig sind, um die gesamte Oberfläche der Matrize 58 zu belichten. Wählt man die Breite 59 eines Segments nicht zu groß, dann spielt die Krümmung der Matrtze 58 keine Rolle. Hierin liegt auch ein weiterer Vorteil dieses Verfahrens. Wegen der völlig freien Gestaltungsmöglichkeit der Größe des LCD-Bildes - es muß nicht auf Rapportmaße Rücksicht genommen werden - kann man die Breite 59 stets hinreichend klein wählen.

In einem jetzt folgenden Behandlungsschritt - der Entwicklung - werden die geschädigten Stellen (beim Positiv-Lack) oder die nicht gehärteten Stellen (beim Negativ-Lack) herausgewaschen. Zurück bleibt eine Matrize, in deren fotolackbeschichtete Oberfläche eine bildhaftes Motiv eingraviert ist, welches aus einer Vielzahl sehr kleiner Rasterpunkte besteht. Diese Rasterpunkte können unterschiedliche Größen aufweisen und sie sind durch Stege getrennt. Dies gilt natürlich nur unter der Voraussetzung, daß das Bild des LCD-Bildschirms 16 auf der Matrizenoberfläche eine ausreichend feine Struktur aufweist und entsprechend angesteuert wird. Wenn der LCD-Bildschirm 16 aber durch optische Mittel auf die Matrizenoberfläche projiziert wird, kann man dies durch eine entsprechende Bildverkleinerung immer erreichen. In den Stegbereichen wird der Fotolack 42 während der Entwicklung vollständig entfernt und die metallische Oberfläche der Matrize 58 liegt dann dort offen. Natürlich kann der Fotolack zusätzlich auch in großflächigen Bereichen vollständig entfernt werden. In einem letzten Behandlungsschritt wird die so vorbehandelte Matrize in ein galvanisches Bad eingehängt und an den nicht durch Fotolack abgedeckten Stellen wird ein Metall galvanisch abgeschieden. Vorzugsweise ist dieses Metall Nickel und das galvanische Bad ist ein Watt'sches Nickelbad oder ein Nickelsulfamatbad. Grundsätzlich könnte der Vorgang auch mit anderen galvanisch abscheidbaren Metallen durchgeführt werden, z. B. mit Kupfer. Während dieses letzten Behandlungsschritts hat man also galvanoplastisch ein Sieb aufgebaut, dessen Siebstruktur dem Motiv des Musterbildes entspricht. Außerdem konnten die Sieböffnungen unterschiedlich groß gehalten werden und auf diese Weise Halbtonmotive in der Schablone erzeugt werden. Die Schablone muß nur noch von der Matrize abgelöst werden. Dies gelingt besonders einfach, wenn in an sich bekannter Weise während des galvanischen Aufbaus der Metallschicht Druckspannungen in dieser Schicht erzeugt werden (organische Badzusätze).

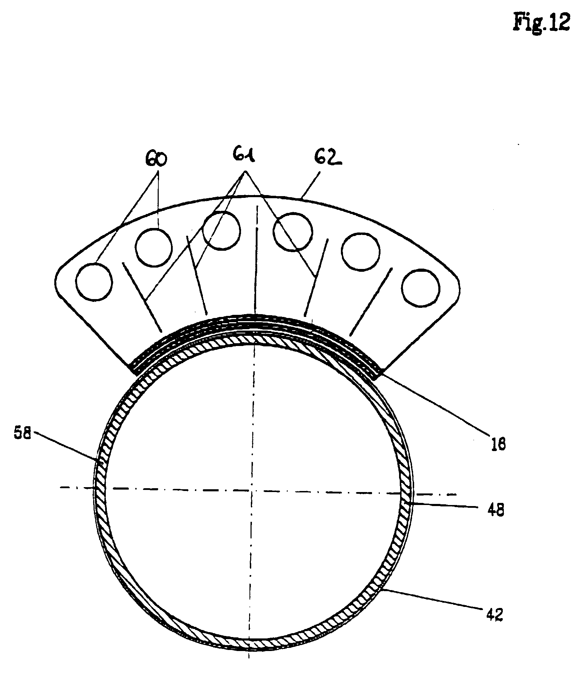

In Figur 12 gelten die Bezeichnungen der Figur 11. Es wird hier ebenfalls die Belichtung einer starren, wenngleich aus Gründen der Gewichtseinsparung und der leichteren Handhabung als Hohlrohr gefertigten Matrize 58 gezeigt. Auch hier wird eine räumlich gekrümmte Oberfläche belichtet, wobei jetzt aber der Belichtungsbereich so stark ausgedehnt ist, daß die Fehler, die durch ein Projektionsbild entstehen wurden, nicht mehr vernachlässigbar sind. Aus diesem Grund ist die LCD-Anzeige 16 in Form einer Zylinderschale ausgeführt. Hinter der LCD-Anzeige 16 sind Leuchtstoffröhren 60 angeordnet, welche den Fotolack 42 durch die nicht abgeschatteten Stellen der LCD-Anzeige 16 hindurch belichten. Wände 61 stehen parallel zur Richtung der Normalen auf die Oberfläche der Matrize 58 und verhindern einen hierzu übermäßig schräg liegenden Lichteinfall. So wird eine Hinterstrahlung der Konturen verhindert. Die Wände 61 und die Leuchtstoffröhren 60 sind durch ein lichtdichtes Gehäuse 62 abgedeckt, so daß der Fotolack 42 nicht vorbelichtet werden kann.

Nach der Erfindung kann ein Einzelrapport des aufzulichtenden Musters völlig unabhängig von den Abmessungen des LCD-Schirms 16 gewählt werden. Zum Beispiel kann der Einzelrapport erheblich größer sein als der LCD-Bildschirm 16 oder dessen Bild auf der Matrize, oder es kann der Einzelrapport auch gradzahlig oder ungradzahlig im LCD-Bildschirm 16 oder dessen Bild auf der Matrize enthalten sein. Dabei kann die Größe eines Vorschubs der LCD-Einrichtung 16 zwischen den einzelnen aufeinanderfolgenden Auflichtvorgängen variieren, und zwar in Abhängigkeit von Forderungen nach einer möglichst fehlerfreien Gesamtmusterzusammensetzung auf der Matrize. Das elektrisch erzeugte Muster aufder LCD-Einrichtung 16 bzw. auf dessen Bildschirm muß demjeweils gewählten Vorschub entsprechen, so daß keine Anschlußfehler entstehen. Die LCD-Einrichtung 16 muß also nicht unbedingt mit konstantem Vorschub zwischen den einzelnen Auflichtvorgängen verschoben werden, da ihr Bildinhalt entsprechend variiert werden kann.

## Patentansprüche

1. Verfahren zur Herstellung einer Druckschablone, bei dem eine aufeinem Schablonen-Grundkörper (41) befindliche lichtempfindliche Schicht (42) musterbedingt belichtet wird, **dadurch gekennzeichnet,** daß die Belichtung über eine Flüssigkristall-Anzeigeeinrichtung (16) erfolgt.

2. Verfahren nach Anspruch 1, **dadurch gekennzeichnet,** daß zur Belichtung größerer Bereiche der die lichtempfindliche Schicht (42) tragende Schablonen-Grundkörper (41) und die Flüssigkristall-Anzeigeeinrichtung (16) relativ zueinander bewegt werden.

3. Verfahren nach Anspruch 1 oder 2, **dadurch gekennzeichnet,** daß eine Lichtaustrittsfläche der Flüssigkristall-Anzeigeeinrichtung (16) bei der Belichtung der lichtempfindlichen Schicht (42) mit dieser in Kontakt kommt.

4. Verfahren nach Anspruch 1 oder 2, **dadurch gekennzeichnet,** daß ein durch die Flüssigkristall-Anzeigeeinrichtung (16) erzeugtes Musterbild durch eine Projektionseinrichtung (45, 46) auf die lichtempfindliche Schicht (42) projiziert wird.

5. Verfahren nach Anspruch 4, **dadurch gekennzeichnet,** daß eine Lichtaustrittsfläche (46) der Projektionseinrichtung (45, 46) bei der Belichtung der lichtempfindlichen Schicht (42) mit dieser in Kontakt kommt.

6. Verfahren nach einem der Ansprüche 1 bis 5, **dadurch gekennzeichnet,** daß ein ebener Schablonen-Grundkörper (41) und eine Flüssigkeitkristall-Anzeigeneinrichtung (16) bzw. Projektionseinrichtung (45, 46) mit ebener Lichtaustrittsfläche zum Einsatz kommen.

7. Verfahren nach einem der Ansprüche 1 bis 5, **dadurch gekennzeichnet,** daß ein flexibler, hohlzylindrischer Schablonen-Grundkörper (41) und eine Flussigkristall-Anzeigeeinrichtung (16) bzw. Projektionseinrichtung (45, 46) mit ebener Lichtaustrittsfläche zum Einsatz kommen.

8. Verfahren nach Anspruch 7, **dadurch gekennzeichnet,** daß der hohlzylindrische Schablonen-Grundkörper (41) bei der Belichtung der lichtempfindlichen Schicht (42) gegen eine ebene Unterlage (48) gedrückt wird.

9. Verfahren nach einem der Ansprüche 1 bis 5, **dadurch gekennzeichnet,** daß ein flexibler oder starrer hohlzylindrischer Schablonen-Grundkörper (41) und eine Flüssigkristall-Anzeigeeinrichtung (16) bzw. Projektionseinrichtung (45, 46) mit entsprechend gewölbter Lichtaustrittsfläche zum Einsatz kommen.

10. Verfahren nach einem der Ansprüche 6 bis 9, **dadurch gekennzeichnet,** daß im Falle eines flexiblen Schablonen-Grundkörpers (41) ein Vakuum zwischen der lichtempfindlichen Schicht (42) und der Lichtaustrittsfläche der Flüssigkristall-Anzeigeeinrichtung (16) bzw. der der Projektionseinrichtung (45, 46) erzeugt wird.

11. Verfahren nach Anspruch 1, **dadurch gekennzeichnet,** daß als Schablonen-Grundkörper (41) ein ebenes oder hohlzylindrisches, flexibles Sieb zum Einsatz kommt.

12. Verfahren nach Anspruch 11, **dadurch gekennzeichnet,** daß als Sieb ein Metallsieb zum Einsatz kommt.

13. Verfahren nach Anspruch 1, **dadurch gekennzeichnet,** daß ein Schablonen-Grundkörper (41) aus flexiblem Metallblech mit geschlossener Oberfläche in ebener oder hohlzylinderförmiger Ausgestaltung zum Einsatz kommt.

14. Verfahren nach Anspruch 1, **dadurch gekennzeichnet,** daß ein Schablonen-Grundkörper aus einem dickem, starrem Metallkörper mit geschlossener Oberfläche in ebener oder hohlzylinderförmiger Ausgestaltung zum Einsatz kommt.

15. Vorrichtung zur Herstellung einer Druckschablone, mit einer Aufspannungseinrichtung (5, 48) zum Aufspannen eines wenigstens eine lichtempfindliche Schicht (42) tragenden Schablonen-Grundkörpers (41), einer Belichtungseinrichtung (13) zum musterbedingten Belichten der lichtempfindlichen Schicht (42), einer Antriebseinrichtung (18 - 27, 50 - 53) zur Relativbewegung von Aufspanneinrichtung (5, 48) und Belichtungseinrichtung (13) gegeneinander, und einer Steuereinrichtung (30) zur Steuerung der Belichtungseinrichtung und der Antriebseinrichtung, **dadurch gekennzeichnet,** daß die Belichtungseinrichtung (13) eine Flügssigkristall-Anzeigeeinrichtung (16) enthält, die durch die Steuereinrichtung (30) ansteuerbar ist.

16. Vorrichtung nach Anspruch 15, **dadurch gekennzeichnet,** daß die Flüssigkristall-Anzeigeeinrichtung (16) so ausgebildet ist, daß die Steuereinrichtung (30) auf ihr größere Musterteilbereiche eines insgesamt auf die lichtempfindliche Schicht (42) aufzubringenden Musters erzeugen kann.

17. Vorrichtung nach Anspruch 15 oder 16, **dadurch gekennzeichnet,** daß die Belichtungseinrichtung (13) eine Projektionseinrichtung (45, 46) enthält, die strahlausgangsseitig zur Flussigkristall-Anzeigeeinrichtung (16) liegt.

18. Vorrichtung nach Anspruch 15, 16 oder 17, **dadurch gekennzeichnet,** daß eine strahlausgangsseitig liegende Begrenzungsplatte (38) der Fltissigkristall-Anzeigeeinrichtung (16) durch senkrecht zur Plattenebene liegende Lichtleiter gebildet ist.

19. Vorrichtung nach einem der Ansprüche 15 bis 18, **dadurch gekennzeichnet,** daß die Belichtungseinrichtung (13) einen optischen Filter aufweist.

20. Vorrichtung nach einem der Ansprüche 15 bis 18, **dadurch gekennzeichnet,** daß die Flüssigkristall-Anzeigeeinrichtung (16) durch einen aufgeweiteten Laserstrahl belichtet wird.

21. Vorrichtung nach einem der Ansprüche 15 bis 20, **gekennzeichnet durch** Mittel (14, 15, 36, 37) zur Erzeugung eines Vakuums zwischen der Strahlausgangsseite der Belichtungseinrichtung (13) und der lichtempfindlichen Schicht (42) des eingespannten Schablonen-Grundkörpers (41).

22. Vorrichtung nach einem der Ansprüche 15 bis 21, **dadurch gekennzeichnet,** daß die Aufspanneinrichtung als ebener Rahmen (5) ausgebildet ist, welcher sich senkrecht zur Rahmenebene bewegen läßt.

23. Vorrichtung nach einem der Ansprüche 15 bis 21, **dadurch gekennzeichnet,** daß die Aufspanneinrichtung in Form eines länglichen Trägers (48) mit ebener Oberfläche ausgebildet ist, auf der senkrecht zur Trägerlängsrichtung der Schablonen-Grundkörper (41) transportierbar ist.

24. Vorrichtung nach Anspruch 23, **dadurch gekennzeichnet,** daß an beiden Enden des Trägers (48) Zahnräder (50) für den Transport des Schablonen-Grundkörpers vorhanden sind, deren Zähne (52) in seitlich in den Schablonen-Grundkörper (41) eingebrachte Perforationen (49) eingreifen.
